# EUROPÄISCHE PATENTSCHRIFT

(11) **EP 0 536 431 B1**
(45) Veröffentlichungstag und Bekanntmachung des Hinweises auf die Patenterteilung: **30.11.1994**
(21) Anmeldenummer: 91117061.1
(22) Anmeldetag: 07.10.1991
(51) Int. Cl.: B23K 26/00, H01L 31/18

(54) **Laserbearbeitungsverfahren für einen Dünnschichtaufbau**
Method for working a thin film device by laser
Méthode pour travailler un dispositif à film mince par laser

(43) Veröffentlichungstag der Anmeldung: 14.04.1993
(73) Patentinhaber: SIEMENS AKTIENGESELLSCHAFT, 80333 München (DE); SIEMENS SOLAR GmbH, 80807 München (DE)
(72) Erfinder: Praschek, Stefan, Dipl.-Ing.(FH), W-8000 München 5 (DE); Riedl, Wolfgang, Dipl.-Phys., Dr. rer. nat., W-8000 München 19 (DE); Goslowsky, Hans, Dipl.-Phys., Dr. rer. nat., W-8018 Grafing (DE)
(74) Vertreter: Fuchs, Franz-Josef, Dr.-Ing.

(56) Entgegenhaltungen:
- US-A- 3 637 410
- US-A- 4 705 698

## Beschreibung

Auf vielen Gebieten der Technik weit verbreitet sind Schneideprozesse mittels Laser, oder allgemein Verfahren zum Materialabtrag mittels Laser. Ein zu bearbeitender Werkstoff wird dabei direkt mit einem Laser geeigneter Wellenlänge bestrahlt, wobei die Strahlungsenergie vom Werkstoff absorbiert und in diesen eingekoppelt zur Verdampfung des Werkstoffs genutzt wird. Die Anwendung reichen dabei vom Schneiden von Stahlblechen über feinmechanische Prozesse bis hin zur Herstellung von mikroelektronischen Bauelementen.

Eine spezielle Anwendung finden Laserbearbeitungsverfahren bei der Strukturierung von Dünnschichtsolarmodulen. Dabei wird das photoaktive Halbleitermaterial zunächst ganzflächig aufgebracht und erst anschließend in mehrere Segmente unterteilt, die seriell miteinander verschaltet werden. Für die im folgenden Strukturierung genannte Unterteilung der Modulfläche muß jede der einzelnen Schichten des Dünnschichtaufbaus, nämlich die Frontseitenelektrode, die Halbleiterschicht sowie die Rückseitenelektrode unterteilt werden. Unter Berücksichtigung der unterschiedlichen Absorptions- und Streueigenschaften der aufeinanderliegenden Schichten und ihrer Grenzflächen können für diese Strukturierung Laser als Werkzeug eingesetzt werden.

Im letzten Schritt wird die Rückseitenelektrode strukturiert. Hierbei besteht das Problem, daß die direkt darunter liegende photoaktive Halbleiterschicht "elektrisch" beschädigt werden kann. Insbesondere bei Solarmodulen aus amorphem Halbleitermaterial besteht die Gefahr einer Phasenumwandlung, die eine elektrisch gut leitende Verbindung zwischen Rück- und Frontseitenelektrode herstellen kann, wenn solche elektrisch gut leitenden Bereiche der Halbleiterschicht eine elektrisch leitende Verbindung zwischen Rück- und Frontseitenelektrode herstellen und diese kurzschließen. Doch auch andere Schädigungen der Halbleiterschicht führen zu einer Verminderung der elektrischen Leistung des Solarmoduls.

Um dies zu vermeiden, erfolgt die Strukturierung der Rückseitenelektrode für ein Dünnschichtsolarmodul üblicherweise mit einer "lift off"-Technik. Dabei wird vor der Abscheidung der Rückseitenelektrode auf der aktiven Halbleiterschicht eine Paste in Form einer dünnen Linie aufgebracht. Diese läßt sich nach der Trocknung mechanisch leicht von der Halbleiterschicht entfernen, wobei der darüber aufgebrachte Teil der Rückseitenelektrode mit entfernt wird. Wesentliche Nachteile dieser "lift off"-Technik sind jedoch:
- aufgrund der Breite des Pastenstreifens wird eine photoinaktive Fläche mit einer Breite größer als 0,5 mm erzeugt,
- durch die "lift oft" -Technik vermindert sich lokal die Haftung zwischen Rückseitenelektrode und aktiver Halbleiterschicht,
- die Photoleitung der aktiven Halbleiterschicht wird möglicherweise durch in der Paste enthaltene chemische Substanzen beeinträchtigt und
- der Strukturierungsprozeß der Rückelektrode erfordert mehrere unterschiedliche Schritte.

Aus der US-A-4 705 698 ist ein verfahren zur Strukturierung einer Dünnschichtsolarzelle aus amorphem Silizium bekannt. Durch Lasereinstrahlung durch das Glassubstrat und die transparente Vorderseitenelektrode aus Zinnoxid hindurch in die aktive Halbleiterschicht wird diese zusammen mit einer darüberliegenden metallischen Rückseitenelektrode im Bereich des Laserfokus abgesprengt.

Es wird ein gepulster Laser verwendet, dessen Pulslänge kleiner als 100 ns und vorzugsweise kleiner als 50 ns beträgt.

Aufgabe der vorliegenden Erfindung ist es daher, ein Laserbearbeitungsverfahren derart zu modifizieren, daß sich damit die besagte Strukturierung der Rückseitenelektrode von Dünnschichtsolarzellen mit TCO-Rückseitenelektroden in einfacher und sicherer Weise durchführen läßt, ohne die elektrische Leistung des Solarmoduls zu beeinträchtigen.

Diese Aufgabe wird erfindungsgemäß gelöst durch ein Verfahren mit den Merkmalen von Anspruch 1.

Weitere Ausgestaltungen der Erfindung sind den Unteransprüchen zu entnehmen.

Im Gegensatz zu bekannten anderen Verfahren zur Materialabtragung mittels Laser wird zu der Erfindung das Material nicht direkt sondern durch darunterliegende transparente Schichten (TCO-Vorderseitenelektrode) bestrahlt, welche das Substrat oder die Trägerschicht des Dünnschichtaufbaus mit umfaßt. Unter transparenter Schicht wird in diesem Zusammenhang eine Schicht verstanden, die für die Wellenlänge des verwendeten Lasers zumindest teilweise durchlässig ist und deren Absorptionskoeffizient bei dieser Wellenlänge deutlich geringer als der der Dünnschicht ist. Somit wird die Laserstrahlung in der Dünnschicht überwiegend in der Nähe der Grenzfläche zur transparenten Schicht absorbiert, so daß eine Lasereinwirkung über die gesamte Schichtdicke der Dünnschicht nicht erforderlich ist. Das Absprengen der vom Laserstrahl erfaßten Bereich der Dünnschicht samt der darüberliegenden Bereiche des gesamten Dünnschichtaufbaus wird durch eine mechanische Verspannung infolge der eingekoppelten Laserenergie erreicht. Durch eine entsprechende Bemessung der Pulslänge und der Energiedichte des Lasers treten aufgrund der erzeugten Verspannungen an der Grenzfläche zwischen transparenter Schicht und der Dünnschicht Beschleunigungskräfte auf, die zum Absprengen der Dünnschicht in diesem Bereich führen. Die Einkopplung der Energie erfolgt dabei so schnell, daß es zu einer nur geringfügigen Erwärmung der transparenten Schicht kommt.

Die freiwerdende kinetische Energie ist ausreichend, um die Dünnschicht rückstandsfrei von dar transparenten Schicht abzusprengen. Somit ist es möglich, bereits mit einem einzigen Laserpuls einen vollständigen Materialabtrag im Bereich des Laserbrennflecks zu bewirken.

Führt man zwischen Einzelpulsen des Lasers eine Relativbewezwischen Laserstrahl und Schichtaufbau derart durch, daß sich die jeweils erzeugten Brennflecken des Lasers noch teilweise überlappen, läßt sich auf diese Weise eine besonders saubere grabenförmige Schnittlinie im Dünnschichtaufbau erzeugen. Durch den rückstandsfreien Materialabtrag im so erzeugten Graben läßt sich der Dünnschichtaufbau sicher unterteilen, ohne daß Brücken aus nicht entferntem Schichtmaterial verbleiben. Dies ist insbesondere für die Anwendung des Verfahrens bei der Strukturierung von Dünnschichtsolarmodulen von Vorteil, bei der durch solche Materialbrücken leitende Verbindungen zwischen voneinander zu trennenden Bereichen des Solarmoduls hergestellt werden könnten, die die besagte Verschlechterung der Moduleigenschaften zur Folge hätten.

In einer vorteilhaften Ausgestaltung der Erfindung wird die Absprengung der bestrahlten Dünnschichtbereiche von der Schwerkraft unterstützt, indem der Schichtaufbau in einer Lage zur Horizontalen bestrahlt wird, bei der die transparente Schicht nach oben weist. Dies umfaßt sämtliche von der Vertikalen abweichenden Anordnungen des Dünnschichtaufbaus, wobei natürlich die horizontale Lage mit nach oben weisender transparenter Schicht die meisten Vorteile erbringt. Dadurch wird auch verhindert, daß abgesprengte Teilchen auf den Aufbau zurückfallen, die ebenfalls zu einem Kurzschluß führen könnten.

Am sichersten arbeitet das Verfahren mit einer transparenten Schicht, die gegenüber dem verwendeten Laser eine vernachlässigbare Absorption aufweist, wobei gleichzeitig die Wellenlänge des Lasers im Bereich des Absorptionsmaximums der Dünnschicht gewählt wird. Dies ist beispielsweise bei Dünnschichtsolarmodulen der Fall, wenn die transparente Schicht ein Glassubstrat mit darüber aufgebrachter transparenter leitfähiger Elektrode (TCO-Schicht) umfaßt und der Dünnschichtaufbau zumindest die aktive Halbleiterschicht umfaßt und gegebenenfalls noch die darüber befindliche Rückelektrodenschicht mit einschließt.

Bei stark absorbierenden Dünnschichtmaterialien kann auch in einem Wellenlängenbereich mit relativ geringerer Absorption eingestrahlt werden, insbesondere um eine Überhitzung zu vermeiden.

Im folgenden wird die Erfindung anhand eines Ausführungsbeispiels und der dazugehörigen vier Figuren näher erläutert.

Die Figuren zeigen im schematischen Querschnitt verschiedene Verfahrensstufen bei der Strukturierung eines Dünnschichtsolarmoduls mit Hilfe des erfindungsgemäßen Verfahrens.

### Ausführungsbeispiel:

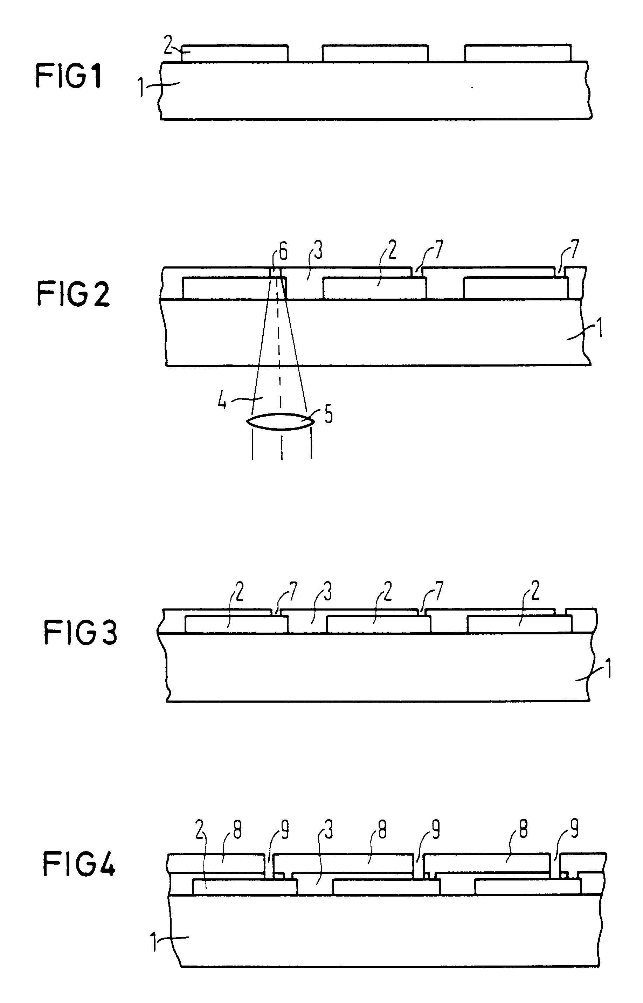

Figur 1: Auf einem Glassubstrat 1, welches beispielsweise 2 mm stark ist, wird in bekannter Weise eine Vorderseitenelektrode aus dünnem leitfähigen Oxid (TCO) abgeschieden, beispielsweise eine 1 µm dicke Schicht aus Zinkoxid oder fluordotiertem Zinnoxid. Durch direkte Bestrahlung mit einem Nd:YAG-Laser wird die ganzflächig aufgebrachte Elektrodenschicht in streifenförmige Einzelelektroden 2 unterteilt.

Figur 2: Über den streifenförmigen Elektroden 2 wird nun eine aktive Halbleiterschicht 3 abgeschieden, beispielsweise amorphes Silizium in einer Dicke von ca. 0,5 µm. Dies geschieht mit einem RF-Glimmentladungs-Abscheideprozeß in Silan, wobei durch Beimischen der Dotiergase Boran (B₂H₆) und Phosphin (PH₃) eine pin-Struktur in der Halbleiterschicht 3 erzeugt wird.

Zur späteren Serienverschaltung der durch die streifenförmigen Elektroden 2 definierten streifenförmigen Einzelsolarzellen muß die photoaktive Schicht 3 ebenfalls streifenförmig strukturiert werden. Erfindungsgemäß wird dazu ein gepulster Laser verwendet, dessen Wellenlänge im Spektralbereich starker Absorption der aktiven Photoschicht liegt. Für amorphes Silizium ist dazu ein blauer oder grüner Laser erforderlich, beispielsweise ein frequenzverdoppelter Nd:YAG- oder Nd:YLF-Laser.

Mittels einer einfachen Optik, bestehend aus einem Spiegel (nicht dargestellt) und einer Linse 5 wird durch das Glassubstrat 1 eingestrahlt und in der aktiven Halbleiterschicht 3 fokussiert. Mit einer Linsenbrennweite von 100 mm wird dabei eine ausreichende Fokustiefe innerhalb eines Toleranzwertes von ± 1 mm erreicht.

Aufgrund der Transparenz von Substrat 1 und der Vorderseitenelektrode 2 wird die Laserstrahlung 4 erst in der aktiven Halbleiterschicht 3 an der Grenze zur Frontseitenelektrode 2 absorbiert. Liegt die Laserpulslänge beispielsweise im Nanosekundenbereich, ruft die Absorption der Laserstrahlung 4 mechanische Spannungen in der Halbleiterschicht 3 hervor. Diese führen zu einem Abspringen des belichteten Bereiches 6 der aktiven Halbleiterschicht 3, wobei dort die Vorderseitenelektrode 2 freigelegt wird.

Eine Untersuchung der Bruchränder der Halbleiterschicht 3 in den erzeugten Vertiefungen 7 zeigt, daß die Halbleiterschicht 3 durch die Wärmeeinwirkung nur wenig phasenverändert ist. Die thermische Belastung der Grenzfläche zwischen Halbleiterschicht 3 und Frontseitenelektrode 2 kann mit einem Gauß-Profil des Laserstrahls und einer optimal gewählten Pulsenergie auf den abgesprengten Schichtbereich 6 und den unmittelbar angrenzenden Randbereich in der Halbleiterschicht 3 lokalisiert werden. Eine radiale Intensitätsverteilung des Laserstrahls mit Gauß-Profil wird erreicht, wenn für das Verfahren die TEMₒₒ-Mode verwendet wird. Weitere Vorteile bringt ein rechteckiges Strahlprofil. Von Vorteil ist ein Profil vor allem dann, wenn die Intensität am Rand steil abfällt.

Durch Pulswiederholung und gleichzeitiges Einstellen einer Relativbewegung zwischen Laserstrahl und Werkstück, bzw. hier dem zukünftigen Solarmodul, können grabenförmige Schnitte in der Dünnschicht- bzw. dem Halbleitermaterial 3 erzeugt werden. In vorteilhafter Weise sind dabei die Pulsfrequenz und die Relativbewegung derart abgestimmt, daß sich die Brennflecken des Lasers teilweise überlappen. So kann die Halbleiterschicht 3 vollständig in hochohmig voneinander getrennte Bereiche unterteilt werden.

Geeignete Pulsfrequenzen liegen im Bereich von 1 bis 100 kHz, wobei die Frequenz nach oben hin zum einen durch die mit steigender Frequenz nachlassende Energiedichte der Laserpulse und zum anderen durch die erforderliche Wärmeableitung aus den nicht abgesprengten Bereichen der Halbleiterschicht und der transparenten Schicht begrenzt ist. Obwohl ein Großteil der eingekoppelten Energie zusammen mit dem bestrahlten Schichtbereich 6 abgesprengt wird, kommt es dennoch zu einer geringfügigen Erwärmung der transparenten Schicht (Elektrodenschicht 2) im bestrahlten Bereich.

Die Länge der Laserpulse beträgt 20 ns bis 100 ps.

Zur Durchführung einer Relativbewegung wird der Laserstrahl definiert über das Modul abgelenkt, oder das Modul relativ zum Strahl bewegt. Die Schneidgeschwindigkeit wird bestimmt durch die Pulswiederholrate, die Ausdehnung des Laserstrahls in Bewegungsrichtung und die Überlappung der erzeugten Brennflecken.

Figur 3 zeigt das Solarmodul in diesem Verfahrensstadium, wobei die Halbleiterschicht 3 durch die erzeugten Gräben 7 entsprechend den Elektrodenstreifen 2 vollständig in einzelne Streifenzellen getrennt ist.

Auf diese Struktur wird nun ganzflächig die Rückseitenelektrode aufgebracht, welche eine transparente TCO-Schicht ist. Die Strukturierung der Rückseitenelektrodenschicht 8 erfolgt entsprechend dem erfindungsgemäßen Verfahren durch Einstrahlung eines gepulsten Lasers durch das transparente Substrat 1 und die transparente Vorderseitenelektrode 2. Entsprechend der bereits beschriebenen Strukturierung der Halbleiterschicht 3 wird der Laser in der Halbleiterschicht 3 fokussiert, wobei im Bereich 9 des Brennflecks zusammen mit der Halbleiterschicht 3 simultan der darüberliegende Bereich der Rückelektrodenschicht 8 abgesprengt wird.

Figur 4 zeigt das fertige Solarmodul, bei dem die einzelnen Streifenzellen durch die entsprechende Strukturierung der Rückseitenelektrode 8 elektrisch miteinander in Serie verschaltet sind.

Gegenüber der herkömmlichen "lift off"-Technik ergeben sich mit dem erfindungsgemäßen Verfahren folgende Vorteile:
- Die Strukturierung der einzelnen Schichten erfolgt einheitlich durch ein Laserverfahren, das heißt es wird nur eine Strukturierungstechnik eingesetzt.
- Die Trenngräben zwischen den Bereichen lassen sich in ihrer Breite auf 30 bis 50 µm begrenzen. Dadurch vergrößert sich die photoaktive Fläche gegenüber der "lift off"-Technik.
- Die durch die Paste bei der "lift off"-Technik hervorgerufenen Haftungsprobleme der Rückseitenelektrode auf der aktiven Halbleiterschicht 3 entfallen.
- Für die Strukturierung der Rückseitenelektrode ist nur noch ein Prozeßschritt erforderlich.

Die beschriebene Strukturierung eines Dünnschichtsolarmoduls aus amorphem Silizium stellt eine geeignete Anwendung des erfindungsgemäßen Verfahrens dar, das jedoch nicht auf diese beschränkt ist.

Das Verfahren läßt sich auch als Reparaturverfahren einsetzen, beispielsweise zum Entfernen stehengebliebener und störender Materialreste, wobei bereits einzelne Laserpulse einen sicheren Materialabtag gewährleisten.

Mit dem Verfahren lassen sich eine Reihe weiterer amorpher und polykristalliner Halbleiterdünnschichten abtragen, insbesondere Germanium haltige oder auch Verbindungshalbleiter wie Kupferindiumdiselenid und andere. Auch dünne Metallfilme auf transparenten Substraten oder Schichten lassen sich mit Erfolg mit dem erfindungsgemäßen Verfahren abtragen oder strukturieren.

Allgemein lassen sich sämtliche dünnen Schichten mit dem Verfahren abtragen, die auf ausreichend transparenten Substraten oder Schichten aufgebracht sind und die eine ausreichende Absorption für das Laserlicht aufweisen. Die thermische Belastung nicht abgetragener Bereiche ist dabei äußerst gering, was insbesondere bei der Strukturierung der Solarmodule beispielsweise aus den Stromspannungskennlinien hervorgeht. Die elektronischen Eigenschaften des Halbleitermaterials bleiben weitestgehend unverändert, so daß die Strukturierung mit dem erfindungsgemäßen Verfahren zu keiner Verschlechterung der Solarzelleneigenschaften führt.

## Patentansprüche

1. Verfahren zur Strukturierung einer Solarzelle mit einem Dünnschichtaufbau, welcher ein transparentes Substrat (1), eine streifenförmig strukturierte TCO-Vorderseitenelektrode (2), eine aktive Halbleiterschicht (3) und eine ganzflächig aufgebrachte TCO-Rückseitenelektrode (8) umfaßt, mit den Merkmalen:
- mit Hilfe eines Lasers werden Laserpulse durch das Substrat (1) und die TCO-Vorderseitenelektrode (2) hindurch in die aktive Halbleiterschicht (3) eingestrahlt
- die Wellenlänge des Lasers wird im Absorptionsbereich der aktiven Halbleiterschicht (3) gewählt
- die Pulslänge des Lasers beträgt 20ns bis 100ps
- dabei wird die aktive Halbleiterschicht (3) samt darüberliegender TCO-Rückseitenelektrode (8) im Bereich der Laserpulse von der TCO-Vorderseitenelektrode (2) abgesprengt
- zwischen Laser und Dünnschichtaufbau wird eine Relativbewegung derart durchgeführt, daß durch den laserinduzierten Materialabtrag eine grabenförmige Schnittlinie (7) in der aktiven Halbleiterschicht (3) erzeugt wird.

2. Verfahren nach Anspruch 1,
bei dem die Relativbewegung derart eingestellt wird, daß die in der Dünnschicht fokusierten Brennflecken des Lasers überlappen und daß so eine grahenförmige Schnittlinie (7) im Dünnschichtaufbau erzeugt wird.

3. Verfahren nach Anspruch 1 oder 2,
bei dem die Absprengung der bestrahlten Dünnschichtbereiche (6) von der Schwerkraft unterstützt wird, indem der Schichtaufbau in einer Lage bestrahlt wird, bei der das Substrat (1) nach oben weist.

4. Verfahren nach einem der Ansprüche 1 bis 3,
bei dem mit einem Laser bestrahlt wird, dessen Wellenlänge im Bereich des Absorptionsmaximums der aktiven Halbleiterschicht (3) gewählt wird.

5. Verfahren nach einem der Ansprüche 1 bis 4,
bei dem die TEMₒₒ-Mode des Lasers verwendet wird.

6. Verfahren nach einem der Ansprüche 1 bis 5,
bei dem für die Laserstrahlführung eine Optik (5) verwendet wird, mit der unerwünschte IR-Strahlung aus dem Strahlengang (4) ausgekoppelt wird.

7. Verwendung des Verfahrens nach einem der vorhergehenden Ansprüche zur Strukturierung aktiver und inaktiver Schichtbereiche von Dünnschichtsolarzellen mit transparenten Substraten (1).

## Claims

1. Method for structuring a solar cell having a thin-film structure, which comprises a transparent substrate (1), a TCO front-surface electrode (2) structured in a strip configuration, an active semiconductor layer (3) and a TCO rear-surface electrode (8) applied over the entire surface, having the features:
- with the aid of a laser, laser pulses are injected through the substrate (1) and the TCO front-surface electrode (2) into the active semiconductor layer (3)
- the wavelength of the laser is selected within the absorption range of the active semiconductor layer (3)
- the pulse length of the laser is 20ns to 100ps
- in this case, the active semiconductor layer (3) along with the superjacent TCO rear-surface electrode (8) is separated off from the TCO front-surface electrode (2) in the region of the laser pulses
- a relative movement is executed between laser and thin-film structure in such a manner that a trench-shaped line of intersection (7) is generated in the active semiconductor layer (3) by the laser-induced removal of material.

2. Method according to Claim 1, in which the relative movement is set in such a manner that the focal spots of the laser which are focussed within the thin film overlap, and that in this manner a trench-shaped line of intersection (7) is generated within the thin-film structure.

3. Method according to Claim 1 or 2, in which the separating off of the irradiated thin-film regions (6) is assisted by gravity in that the film structure is irradiated in a position in which the substrate (1) points upwards.

4. Method according to one of Claims 1 to 3, in which irradiation takes place using a laser, the wavelength of which is selected within the region of the absorption maximum of the active semiconductor layer (3).

5. Method according to one of Claims 1 to 4, in which the TEMₒₒ mode of the laser is used.

6. Method according to one of Claims 1 to 5, in which an optical system (5) is used for the laser beam guidance, by which optical system undesired IR radiation is coupled out from the beam path (4).

7. Use of the method according to one of the preceding claims for the structuring of active and inactive film regions of thin-film solar cells with transparent substrates (1).

## Revendications

1. Procédé pour structurer une pile solaire comportant une structure à couche mince, qui comprend un substrat transparent (1), une électrode de face avant TCO (2) structurée en forme de bande, une couche semiconductrice active (3) et une électrode de face arrière TCO (8) déposée sur toute la surface, et présentant les caractéristiques suivantes :
- des impulsions laser sont introduites à l'aide d'un laser, dans la couche semiconductrice active (3), en traversant le substrat (1) et l'électrode de face avant TCO (2),
- on choisit la longueur d'onde du laser dans la gamme d'absorption de la couche semiconductrice active (3),
- la longueur des impulsions du laser est comprise entre 20 ns et 100 ps,
- la couche semiconductrice active (3), y compris l'électrode de face arrière TCO (8) située sur cette couche, sont éliminées de l'électrode de face avant TCO (2) dans la zone des impulsions laser, et
- on exécute un déplacement relatif entre le laser et la structure à couche mince de telle sorte qu'une ligne de coupe en forme de sillon (7) est formée dans la couche semiconductrice active (3), sous l'effet de l'enlèvement de matière qui est provoqué par le laser.

2. Procédé suivant la revendication 1, selon lequel le déplacement relatif est réglé de telle sorte que les spots focaux du laser, qui sont focalisés dans la couche mince, se chevauchent et qu'on obtient ainsi, dans la structure à couche mince, une ligne de coupe en forme de sillon (7).

3. Procédé suivant la revendication 1 ou 2, selon lequel, l'élimination des zones irradiées (6) de la couche mince est assistée par la force de pesanteur par le fait que la structure de couche est irradiée dans une position dans laquelle le substrat (1) est tourné vers le haut.

4. Procédé suivant l'une des revendications 1 à 3, selon lequel on réalise l'irradiation avec un laser dont la longueur d'onde est choisie au voisinage du maximum d'absorption de la couche semiconductrice active (3).

5. Procédé suivant l'une des revendications 1 à 4, selon lequel on utilise le mode TEMₒₒ du laser.

6. Procédé suivant l'une des revendications 1 à 5, selon lequel, pour le guidage du faisceau laser, on utilise un système optique (5) à l'aide duquel un rayonnement infrarouge indésirable est découplé du trajet de rayonnement (4).

7. Utilisation du procédé suivant l'une des revendications précédentes, pour la structuration de régions actives et inactives de couches de piles solaires à couches minces comportant des substrats transparents (1).
